# EUROPEAN PATENT SPECIFICATION

(11) **EP 2 357 654 B1**
(45) Date of publication and mention of the grant of the patent: **25.11.2015**
(21) Application number: 09823395.0
(22) Date of filing: 04.08.2009
(51) Int. Cl.: G11C 15/04, G06F 11/10

(54) **PARALLEL CONTENT ADDRESSABLE MEMORY**
PARALLELER INHALTSADRESSIERBARER SPEICHER
MÉMOIRE ASSOCIATIVE PARALLÈLE

(30) Priority: 28.10.2008 JP 2008276472
(43) Date of publication of application: 17.08.2011
(73) Proprietor: International Business Machines Corporation, Armonk, NY 10504 (US)
(72) Inventor: MIYATAKE Hisatada, Tokyo 103-8510 (JP)
(74) Representative: Williams, Julian David
(86) International application number: PCT/JP2009/063784
(87) International publication number: WO 2010/050282

(56) References cited:
- JP-A- 9 022 595
- US-A- 3 316 542
- US-A- 6 067 656
- SCHULTZ K J: "Content-addressable memory core cells A survey", INTEGRATION, THE VLSI JOURNAL, NORTH-HOLLAND PUBLISHING COMPANY. AMSTERDAM, NL, vol. 23, no. 2, 1 November 1997 (1997-11-01), pages 171-188, XP004102252, ISSN: 0167-9260, DOI: 10.1016/S0167-9260(97)00021-7

## Description

### FIELD OF THE INVENTION

The present invention relates to a parallel associative memory, and more particularly to a parallel associative memory for searching all the addresses at the same time and determining whether or not the same data as input data is stored.

### BACKGROUND OF THE INVENTION

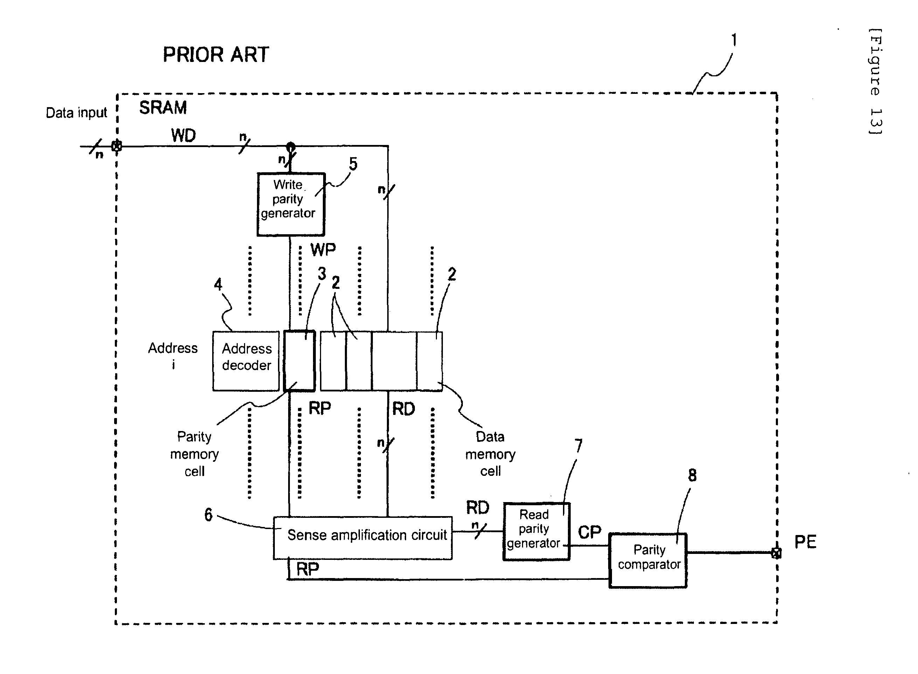

Figure 13 is a functional block diagram showing the configuration of a conventional SRAM (Static Random Access Memory) having a parity check function. Referring to Figure 13, the SRAM 1 comprises n (natural number) data memory cells 2, one parity memory cell 3, and an address decoder 4. They are provided in plural sets of the same configuration. This SRAM 1 further comprises a write parity generator 5, a sense amplification circuit 6, a read parity generator 7, and a parity comparator 8.

At the data write time, the address decoder 4 selects n data memory cells 2 and the corresponding parity memory cell 3 in accordance with a write address i. N-bit data WD inputted from the outside is written into the selected data memory cells 2. At this time, the write parity generator 5 calculates a parity WP, based on the input n-bit data WD. The calculated parity WP is written into the parity memory cell 3.

On the other hand, at the data read time, the address decoder 4 selects n data memory cells 2 and the corresponding parity memory cell 3 in accordance with a read address i. Then, n-bit data RD is read from the selected data memory cells 2, and a parity RP is read from the selected parity memory cell 3, in which they are sensed and amplified by the sense amplification circuit 6. The read parity generator 7 calculates a parity CP, based on the read n-bit data RD. The parity comparator 8 compares the calculated parity CP and the parity RP read from the parity memory cell 3, and outputs a parity error signal PE if there is mismatch in each of the parities (between two parities).

In this way, the parity check is performed by reading the data RD from each address and calculating its parity CP, so it is sufficient for the SRAM 1 because the data RD is read from only one designated address in the SRAM 1.

On the other hand, there is a parallel associative memory or parallel content-addressable memory (hereinafter referred to as a "parallel CAM (Content- Addressable Memory)") that can search all the addresses at the same time, and output the address(es) at which the same data as input data is(are) stored or read out the associative data associated with the data. It is desired that the parallel CAM also has a parity check function. Particularly, it is desired that the parity check is performed at the data search operation that is an intrinsic and main function of the parallel CAM.

However, if the parity check is performed for all the addresses for search at the data search time in the same way as described above, it is required to read the data from each address and calculate the parity for each address, whereby it takes too long time to perform the parity check.

In U.S. Patent No. 7010741 (Patent Document 1) and U.S. Patent No. 7350137 (Patent Document 2), CAM having a parity check function has been disclosed, in which the parity check is performed by reading the data, but not performed at the data search time.

Also, in Published Unexamined Patent Application No. 63-177242 (Patent Document 3), a parity check method for the associative memory has been disclosed. In the same patent, in the lower left column, lines 1 to 11 at page 2, there is a description that "with the prior art, the parity check for a memory cell array for searched data is performed by reading the memory cell array for the searched data, generating a parity of the data and comparing it with parity information held beforehand. That is, to perform the parity check, one series of operations, including access to the memory cell array, generation of the parity and comparison, are required, resulting in a problem that it takes too long time to perform the parity check. An object of the invention is to provide a parity check method for detecting a data error at high speed."

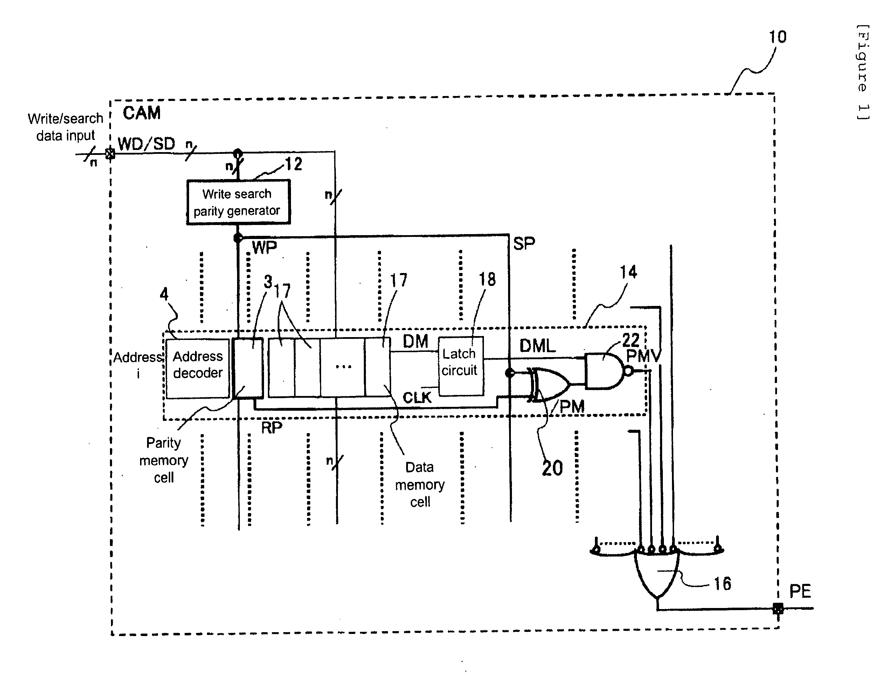

This associative memory, in one of its examples, comprises an address register 1, a searched data memory cell array 2 for storing searched data, a sense circuit 3 for amplifying the searched data, a parity memory cell array 2' for storing the parity of the searched data, a sense circuit 3' for amplifying the parity, a comparison circuit 4, a parity generation circuit 5, a comparison circuit 4', and a signal validation circuit 6, as shown in Figure 1 of the same patent. The higher-order bits a of the address outputted from the address register 1 are search data, and the lower-order bits b are an address for selecting one data memory cell from an array of the searched data memory cells 2. The comparison circuit 4 compares the search data a with the searched data d read and amplified in accordance with the address, and outputs a hit signal g if matched. The parity generation circuit 5 generates a parity f of the search data a. The comparison circuit 4' compares the parity f with the parity d' read and amplified in accordance with the address. The signal validation circuit 6 validates the output h of the comparison circuit 4' using (in response to) the hit signal g and outputs a parity check signal i. In this example, since the parity generated from the search data can be used in the parity check for the searched data memory cell, the faster operation can be made than the parity is generated from the searched data.

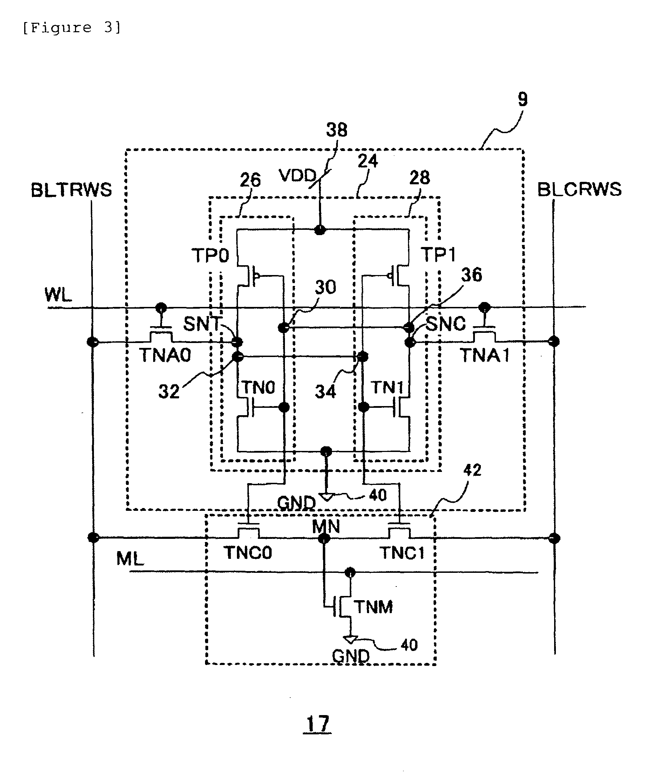

Also, in another example, there is provided a match detection circuit 7 for detecting a match between a data line c that is a signal of low amplification level outputted from the memory cell within the searched data memory cell array 2 and the search data a and outputting a hit signal g, instead of the sense circuit 3 and the comparison circuit 4 of the above example, as shown in Figure 3 of the same patent. Using the match detection circuit 7, the hit signal g can be obtained fast, because the signal of low amplitude level is not amplified for match detection. However, they are not different in that the parity check is performed using both the data and the parity read out in accordance with the address.

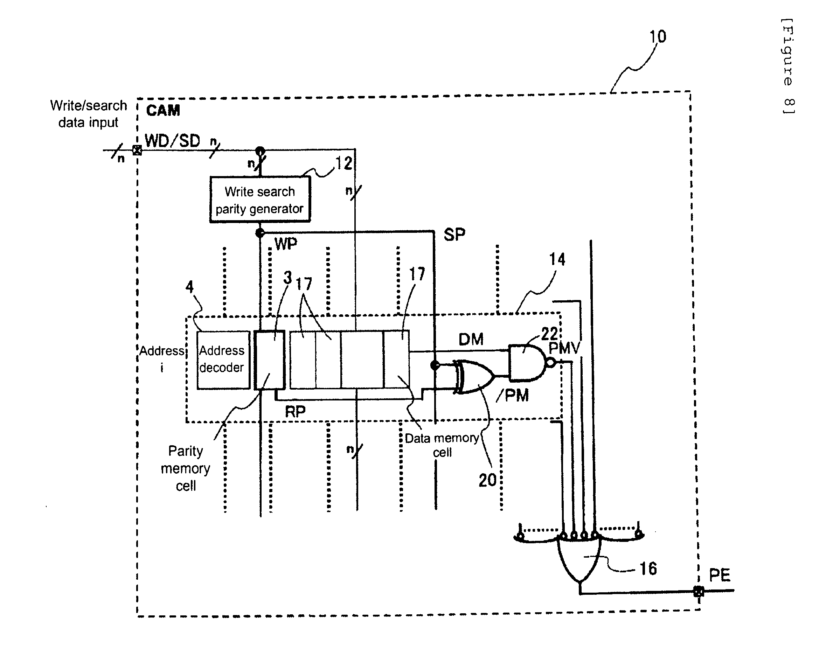

In a further example, there is provided a match detection circuit 7' for detecting a match between a data line c' that is a signal of low amplification level outputted from the memory cell within the parity memory cell array 2' and the parity f generated from the search data a, and outputting an output h, instead of the sense circuit 3 and the comparison circuit 4' of the above another example, as shown in Figure 8 of the same patent. Using the match detection circuit 7', the parity check signal i can be obtained faster, because the signal of low amplitude level is not amplified for match detection. However, they are not different in that the parity check is performed using both the data and the parity read out in accordance with the address.

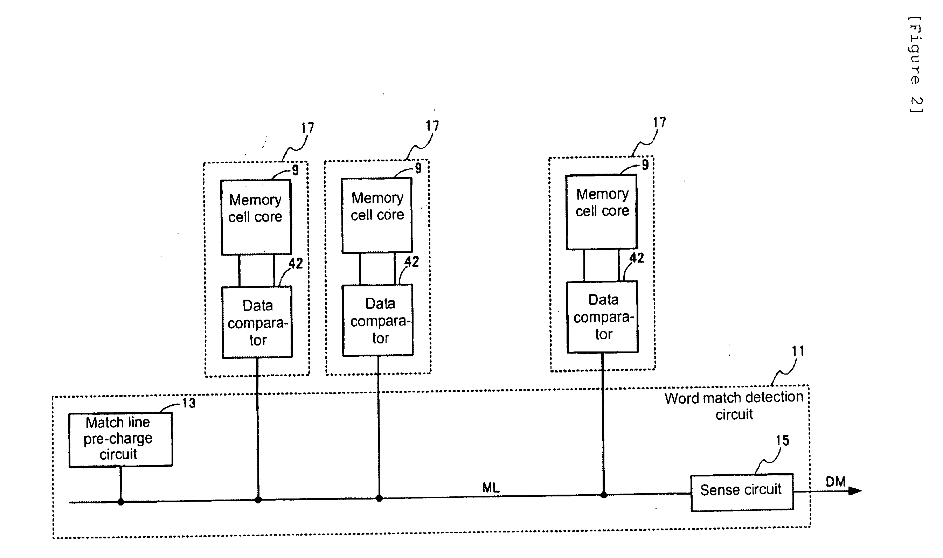

This associative memory is not a parallel CAM for searching all the addresses at the same time but a serial CAM for searching the addresses one by one. That is, one address is selected from the searched data memory cell array 2 in accordance with the address given from the address register 1, and the searched data is read from that address. The comparison circuit 4 or the match detection circuit 7 compares the read searched data with the search data given from the address register 1. Meanwhile, one address is selected from the parity memory cell array 2' in accordance with the address given from the address register 1, and the parity is read from that address. The comparison circuit 4' or the match detection circuit 7' compares the read parity with the parity generated by the parity generation circuit 5. In this way, the comparison circuits 4, 4' or the match detection circuits 7, 7' are provided outside the memory cell arrays 2, 2', whereby the data and parity at one address can be only checked at a time. Also, the data must be read from the memory cell before comparing the parity, as shown in Figure 2C and 2C' of the same patent.

Also, in Published Unexamined Patent Application No. 9-22595 (Patent Document 4), an associative storage device has been disclosed. In the same patent, in the right column, lines 24 to 48 at page 2, there is a description that "the associative storage device comprises a data memory for managing the processing data of a search object, and a directory memory for managing the directory data corresponding one-to-one to the processing data, and when the search data is given, the directory data matched with the search data is searched from the directory data managed by the directory memory, and the processing data designated by it is read from the data memory. In the associative storage device configured in this way, the parity bit of the processing data is stored in the data memory, corresponding to the processing data, and when the processing data designated by the search data is read, the parity bit paired with it is read, the parity bit of the read processing data is calculated, whether or not there is a match between the calculated parity bit and the read parity bit is judged, and the read processing data is checked for corruption. However, with the prior art, it is possible to detect whether or not the processing data stored in the data memory is corrupted, but whether or not the directory data managed by the directory memory is corrupted can not be detected, even if data is corrupted. Therefore, with the prior art, if the directory data is corrupted, the directory data that should not be hit essentially is searched, resulting in a problem that the erroneous processing data is outputted from the data memory. This invention has been achieved in the light of such circumstances, and an object of the invention is to provide a new associative storage device that can surely detect whether or not the hit processing data with the search data is corrupted."

This associative storage device in one of its examples comprises a data memory 20 for storing the processing data, a directory memory 21 for storing the directory data corresponding one-to-one to the processing data and outputting a hit signal for the directory data matched with the search data, a parity memory 22, expanded over the same memory as the data memory 20, for storing the parity of the directory data corresponding to the processing data, a parity generation circuit 24 for generating the parity bit of the search data, and a parity check circuit 25 for checking whether or not the parity bit generated by the parity generation circuit 24 and the parity bit outputted from the parity memory 22 are matched, as shown in Figure 3 of the same patent.

However, in the same patent, a circuit for comparing the search data and the directory data, and generating a hit signal if there is a match in the data is not described in detail. Also, there is no description about means for making the arbitration when there are a plurality of matches. This associative storage device, like the associative memory as described in Published Unexamined Patent Application No. 63-177242, can check the data and parity at only one address at a time, as seen from the described configuration.

US 6,067,656 describes a method and apparatus for detecting soft errors in content addressable memory arrays. This document discloses the preamble of claim 1.

US 3,316,542 describes double signal to noise ratio in a search memory.

Schultz K J: "Content-addressable memory core cells A survey" Integration, The VLSI Journal, North-Holland Publishing Company, Amsterdam, NL, vol.23, no.2, 1 November 1997, pages 171-188, XP004102252, ISSN: 0167-9260, DOI: 10.1016/SO167-9260(97) 00021-7, is also considered relevant technological background art.

### SUMMARY OF THE INVENTION

The present invention provides a parallel associative memory as claimed in claim 1.

It is an object of the invention to provide a parallel associative memory that can check the parity of input data and the parity of stored data at high speed. Particularly, the invention is intended to perform the parity checks for plural pieces of effective search object data simultaneously without sacrificing the search speed at the data search time.

According to the invention, a parallel associative memory for searching all the addresses at the same time and determining whether or not the same data as input data is stored comprises parity generation means for generating a parity of n-bit data inputted at write time and search time, and a plurality of memory locations corresponding to a plurality of addresses. Each of the memory locations comprises n CAM memory cells for storing the n-bit data inputted at the write time and comparing the n-bit data inputted at the search time and the stored n-bit data, a parity memory cell for storing the parity generated by the parity generation means at the write time, and parity check means for judging whether or not the parity generated by the parity generation means at the search time and the parity stored in the parity memory cell are matched.

With the invention, since the parity generated by the parity generation means at the search time and the parity stored in the parity memory cell are compared, the parity check can be performed fast. Moreover, since the data and parity are checked at the same time in all the memory locations corresponding to all the addresses, the parity check can be performed faster.

The parity check means activates a parity match signal if there is a match in the parity. Each of the memory locations further comprises a word match detection circuit for activating a word data match signal if the n-bit data inputted at the search time and the n-bit data stored in the CAM memory cells are matched, and parity validation means for validating the parity match signal outputted from the parity check means using (in response to) the word data match signal activated by the word match detection circuit.

In this case, since the parity match signal outputted from the parity check means is validated only if the input data and the data stored in the CAM memory cell are matched, meaningless parity match signals are not outputted from the memory locations in which there is no match in the data.

The parallel associative memory further comprises parity error detection means for activating a parity error signal if at least one of a plurality of parity match signals validated by the parity validation means and outputted from the plurality of memory locations is inactive.

In this case, since the parity error signal is activated if at least one of the plurality of validated parity match signals is inactive, one can judge that the parallel associative memory contains erroneous data, when there is a parity error in any of memory locations in which the valid data are stored.

### BRIEF DESCRIPTION OF THE DRAWINGS

Figure 1 is a functional block diagram showing the configuration of a parallel CAM according to the first embodiment of the present invention;
Figure 2 is a functional block diagram showing the configuration of a CAM memory cell and a word match detection circuit in Figure 1;
Figure 3 is a circuit diagram showing the configuration of the CAM memory cell and its peripheral circuit in Figure 1;
Figure 4 is a circuit diagram showing the configuration of a parity memory cell and its peripheral circuit in Figure 1;
Figure 5 is a circuit diagram showing another example of the parity memory cell and its peripheral circuit as shown in Figure 4;
Figure 6 is a functional block diagram showing the configuration of a parallel CAM according to the second embodiment of the invention;
Figure 7 is a circuit diagram showing the configuration of a CAM memory cell and its peripheral circuit in Figure 6;
Figure 8 is a functional block diagram showing the configuration of a parallel CAM according to the third embodiment of the invention;
Figure 9 is a functional block diagram showing the configuration of a parallel CAM according to the fourth embodiment of the invention;
Figure 10 is a circuit diagram showing the configuration of a parity memory cell and its peripheral circuit in Figure 9;
Figure 11 is a functional block diagram showing the configuration of a parallel CAM according to the fifth embodiment of the invention;
Figure 12 is a circuit diagram showing the configuration of the parity memory cell and its peripheral circuit in Figure 11; and
Figure 13 is a functional block diagram showing the conventional parity checking.

### DESCRIPTION OF EMBODIMENTS

The embodiments of the present invention will be described below in detail with reference to the drawings. Throughout the drawings, the same or like parts are designated by the same numerals, and the explanation is not repeated.

### First embodiment

Referring to Figure 1, a parallel CAM 10 according to the first embodiment of the invention searches all the addresses at the same time, and determines whether or not the same data as input data is stored. The parallel CAM 10 comprises a write search parity generator 12, a plurality of memory locations 14 corresponding to a plurality of addresses, and a NAND circuit (negative logic) 16. In Figure 1, one memory location 14 is typically illustrated.

The write search parity generator 12 generates parities WP and SP of n-bit data WD and SD inputted at write time and search time, respectively. Each of the memory locations 14 comprises n (natural number) CAM memory cells 17, one parity memory cell 3, an address decoder 4, a latch circuit 18, an exclusive OR circuit 20 and a NAND circuit 22.

Referring to Figure 2, each of the CAM memory cells 17 comprises a memory cell core 9 and a data comparator 42. Also, the n-th CAM memory cells 17 has a function of storing the n-bit write data WD inputted at the write time and a function of comparing the n-bit search data SD inputted at the search time and the stored n-bit write data WD. Each memory cell core 9 stores the corresponding one bit of the write data WD. Each data comparator 42 compares the corresponding one bit of the search data SD and the one bit of the write data WD stored in the corresponding memory cell core 9.

Each of the memory locations 14 further comprises a word match detection circuit for activating a word data match signal DM to a high level (power source potential VDD) if the n-bit search data SD inputted at the search time and the n-bit data stored in the CAM memory cells 17 are matched. More specifically, the word match detection circuit 11 comprises a search match line ML, a match line pre-charge circuit 13, and a sense circuit 15. The match line pre-charge circuit 13 pre-charges the search match line ML to a high level. Each data comparator 42 discharges the search match line ML to a low level (ground potential GND) if the corresponding one bit of the search data SD and the one bit of the data stored in the corresponding memory cell core 9 are not matched. The sense circuit 15 senses and amplifies the potential of the search match line ML.

Returning to Figure 1, the parity memory cell 3 stores the parity WP generated by the write search parity generator 12 at the write time.

The latch circuit 18 latches the word data match signal DM in response to a clock signal CLK. The exclusive OR circuit 20 judges whether or not the parity SP generated by the write search parity generator 12 at the search time and the parity RP (= WP) stored in the parity memory cell 3 are matched, and activates a parity match signal /PM in negative logic, if they are matched. The NAND circuit 22 validates the parity match signal /PM outputted from the exclusive OR circuit 20 using a word data match signal DML latched by the latch circuit 18. In the case where the latched word data match signal DML is activated to the high level and there is a match of data, when the parity match signal /PM is activated to the low level (ground potential GND) and there is a match of parity, a valid parity match signal PMV is activated to the high level, indicating that there is a match of both the data and the parity. On the other hand, in the case where the latched word data match signal DML is activated to the high level and there is a match of data, when the parity match signal /PM is deactivated to the high level and there is a mismatch of parity, the valid parity match signal PMV is deactivated to the low level, indicating that there is a match of data but there is a mismatch of parity.

The NAND circuit 16 activates a parity error signal PE if at least one of a plurality of valid parity match signals PMV outputted from the plurality of memory locations 14 is at the low level (inactive).

Referring to Figure 3, the CAM 10 further comprises read write search bit lines BLTRWS and BLCRWS and a word line WL. The bit lines BLTRWS and BLCRWS are provided in n pairs corresponding to the n CAM memory cells 17, though only one pair is typically illustrated in Figure 3. A plurality of word lines WL are provided corresponding to the plurality of memory locations, though only one line is typically illustrated in Figure 3. A plurality of search match lines ML are provided corresponding to the plurality of memory locations, though only one line is typically illustrated in Figure 3.

The bit lines BLTRWS and BLCRWS are pre-charged to the high level at data read time and data write time, and pre-charged to the low level at data search time. The word line WL is driven to the high level at data read time and data write time. The search match line ML is pre-charged to the high level at data search time.

If the n-bit data SD given from the outside and the n-bit data stored in the CAM memory cells 17 are all matched, the search match line ML is not discharged, and kept at the high level. On the other hand, the n-bit data given from the outside and the n-bit data stored in the CAM memory cells 17 are not matched even in one bit, the search match line ML is discharged to the low level. The potential of the search match line ML is sensed and amplified by the sense circuit 15 within the word match detection circuit 11 as shown in Figure 2, whereby if there is a match of data, the word data match signal DM is put at the high level, and if there is a mismatch of data, the word data match signal DM is put at the low level.

The memory cell core 9 comprises a latch circuit 24 for holding one bit of data, and access transistors TNA0 and TNA1 composed of an n-channel MOS transistor respectively. The latch circuit 24 comprises CMOS (Complementary Metal Oxide Semiconductor) inverters 26 and 28 cross-coupled each other. The input node 30 of the CMOS inverter 26 is connected to the storage node SNC, and its output node 32 is connected to the storage node SNT. The input node 34 of the CMOS inverter 28 is connected to the storage node SNT, and its output node 36 is connected to the storage node SNC.

The CMOS inverter 26 comprises a load transistor TP0 composed of a p-channel MOS transistor and a drive transistor TN0 composed of an n-channel MOS transistor. The gate of the load transistor TP0 is connected to the input node 30, its source is connected to a power source 38, and its drain is connected to the output node 32. The gate of the drive transistor TN0 is connected to the input node 30, its source is connected to the ground 40, and its drain is connected to the output node 32.

The CMOS inverter 28 comprises a load transistor TP1 composed of a p-channel MOS transistor and a drive transistor TN1 composed of an n-channel MOS transistor. The gate of the load transistor TP1 is connected to the input node 34, its source is connected to the power source 38, and its drain is connected to the output node 36. The gate of the drive transistor TN1 is connected to the input node 34, its source is connected to the ground 40, and its drain is connected to the output node 36.

The gate node of the access transistor TNA0 is connected to the word line WL, one of its source/drain nodes is connected to the bit line BLTRWS and the other of its source/drain nodes is connected to the storage node SNT. The gate node of the access transistor TNA1 is connected to the word line WL, one of its source/drain nodes is connected to the bit line BLCRWS and the other of its source/drain nodes is connected to the storage node SNC.

The data comparator 42 compares the input data given via the bit lines BLTRWS and BLCRWS with the data stored in the latch circuit 24. More specifically, the data comparator 42 comprises comparison transistors TNC0 and TNC1 composed of an n-channel MOS transistor respectively and a match transistor TNM composed of an n-channel MOS transistor. The gate node of the comparison transistor TNC0 is connected to the storage node SNC, one of its source/drain nodes is connected to the bit line BLTRWS and the other of its source/drain nodes is connected to a bit match node MN. The gate node of the comparison transistor TNC1 is connected to the storage node SNT, one of its source/drain nodes is connected to the bit line BLCRWS, and the other of its source/drain is connected to the bit match node MN. The gate of the match transistor TNM is connected to the bit match node MN, its source is connected to the ground 40, and its drain is connected to the search match line ML.

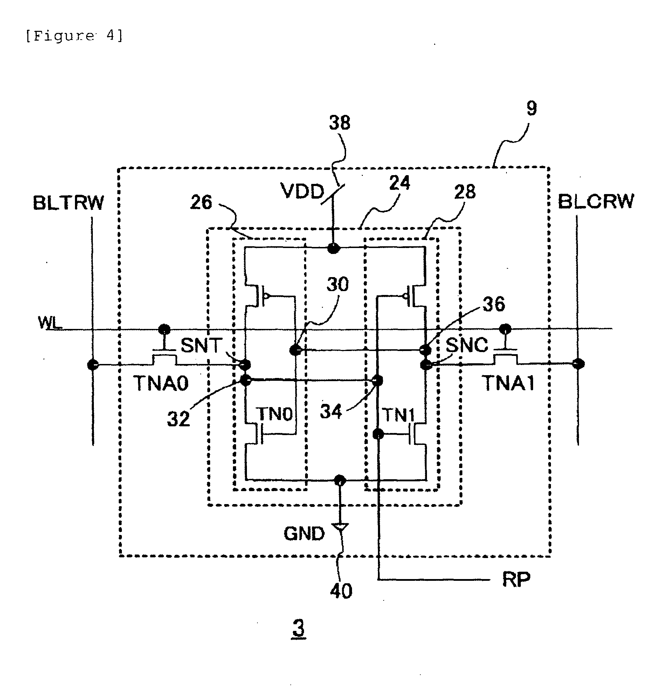

Referring to Figure 4, the parity memory cell 3 has the same memory cell core 9 as the CAM memory cells 17. However, the parity memory cell 3 does not have the data comparator 42 contained in the CAM memory cells 17. Also, the potential of the storage node SNT is directly read as the parity RP. Also, the bit lines BLTRW and BLCRW are used for both read and write, and pre-charged to the high level at data read time and data write time, but not particularly changed at data search time. A total of (n+1) pairs of bit lines are provided, including the read write bit lines BLTRW and BLCRW and the read write search bit lines BLTRWS and BLCRWS.

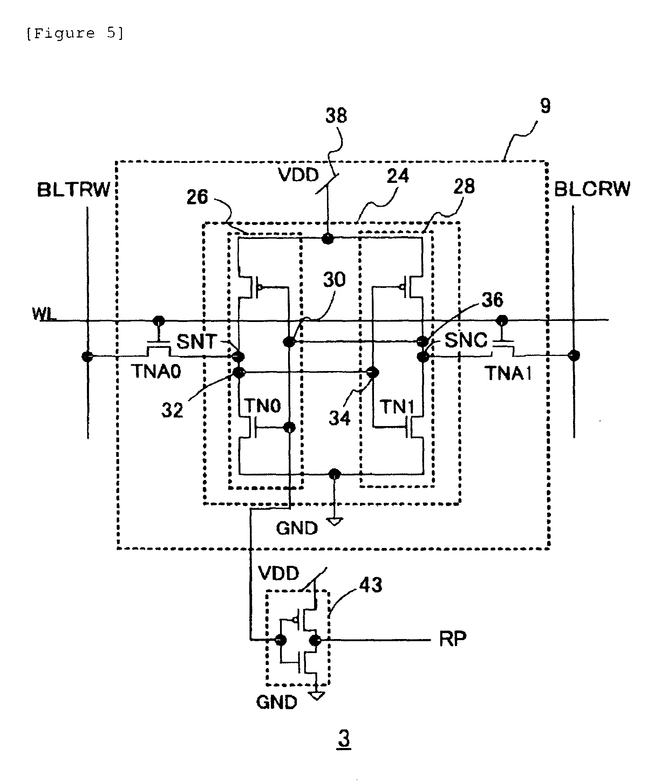

Though the parity RP is read from the storage node SNT in Figure 4, it may be read from the other storage node SNC as shown in Figure 5. In this case, a CMOS inverter 43 is inserted to adjust the logical level.

The operation of this CAM 10 will be described below.

The write operation and read operation are essentially the same as the conventional. To outline them, in the write operation, the inputted n-bit data WD is written into the n CAM memory cells 17. At the same time, the parity WP is calculated based on the n-bit data WD by the write search parity generator 12. The calculated parity WP is written into the parity memory cell 3. On the other hand, in the read operation, the n-bit data is read from the n CAM memory cells 17. In reading, the parity check is performed by the conventional method as described in the section "Background Art".

The search operation is different from the conventional one and will be detailed below. To search the data stored in the CAM memory cells 17, first of all, the search match line ML is pre-charged to the high level and the bit lines BLTRWS and BLCRWS are pre-charged to the low level. At this time, the comparison transistor TNC0 or TNC1 is turned on according to the storage node SNT or SNC which is at the high level, so that the bit match node MN is put at the low level. Accordingly, the match transistor TNM is off. In this state, if the data SD to be searched is given to the bit lines BLTRWS and BLCRWS, the bit match node MN is kept at the low level in the CAM memory cells 17 in which the data SD to be searched and the stored data are matched, but the bit match node MN rises toward the high level in the CAM memory cells 17 in which they are not matched. Accordingly, the match transistor TNM is turned on in the CAM memory cells 17 in which there is a mismatch of data, so that the search match line ML is pulled down to the low level, indicating the mismatch of data. That is, if the n-bit data SD inputted at the search time and the n-bit data stored in the CAM memory cells 17 are matched, the word data match signal DM is activated to the high level. On the other hand, if these data are not matched even in one bit, the word data match signal DM is deactivated to the low level. The word data match signal DM is latched by the latch circuit 18.

At the same time, the parity SP is calculated based on the n-bit search data SD by the write search parity generator 12. Also, the parity RP is read from the parity memory cell 3. The calculated parity SP and the read parity RP are compared by the exclusive OR circuit 20. If the parity SP and the parity RP are matched, the parity match signal /PM is put at the low level, and if the parity SP and the parity RP are not matched, the parity match signal /PM is put at the high level. Since the parity match signal /PM is meaningless in the memory location 14 in which there is a mismatch of data, if the word data match signal DML latched by the latch circuit 18 is at the high level, the parity match signal PM is validated by the NAND circuit 22. If the parity SP and the parity RP are matched, the valid parity match signal PMV is put at the high level, and if the parity SP and the parity RP are not matched, the valid parity match signal PMV is put at the low level.

The n-bit search data SD is given to all the memory locations 14 at the same time, whereby the above operation is performed in all the memory locations 14 at the same time. In the memory location 14 in which the input n-bit search data SD and the stored n-bit data are matched, the word data match signal DM is put at the high level. Accordingly, the meaningful valid parity match signal PMV is outputted from this memory location 14. If at least one of the plurality of valid parity match signals PMV outputted from the plurality of memory locations 14 is at the low level indicating the mismatch of parity, the parity error signal PE is put at the high level.

With the first embodiment as described above, at the data search time, the parity computed based on the data read out of the CAM memory cells 17 is not compared with the parity RP stored in the parity memory cell 3, but the parity SP computed by the write search parity generator 12 and the parity RP stored in the parity memory cell 3 are compared with each other, whereby the parity check can be performed at high speed. Moreover, since the data and parity are checked at the same time in all the memory locations 14 corresponding to all the addresses, the parity check can be performed at higher speed.

Also, the parity match signal /PM outputted from the exclusive OR circuit 20 is validated, only if the search data SD inputted from the outside and the data stored in the CAM memory cells 17 are matched, whereby the meaningless parity match signal /PM is not outputted from the memory location 14 in which there is a mismatch of data.

Also, if at least one of the plurality of valid parity match signals PMV is at the low level, the parity error signal PE is put at the high level, whereby one can judge that the parallel CAM 10 contains the erroneous data, when a parity error exists in any of the memory locations 14 in which the valid data are stored.

### Second embodiment

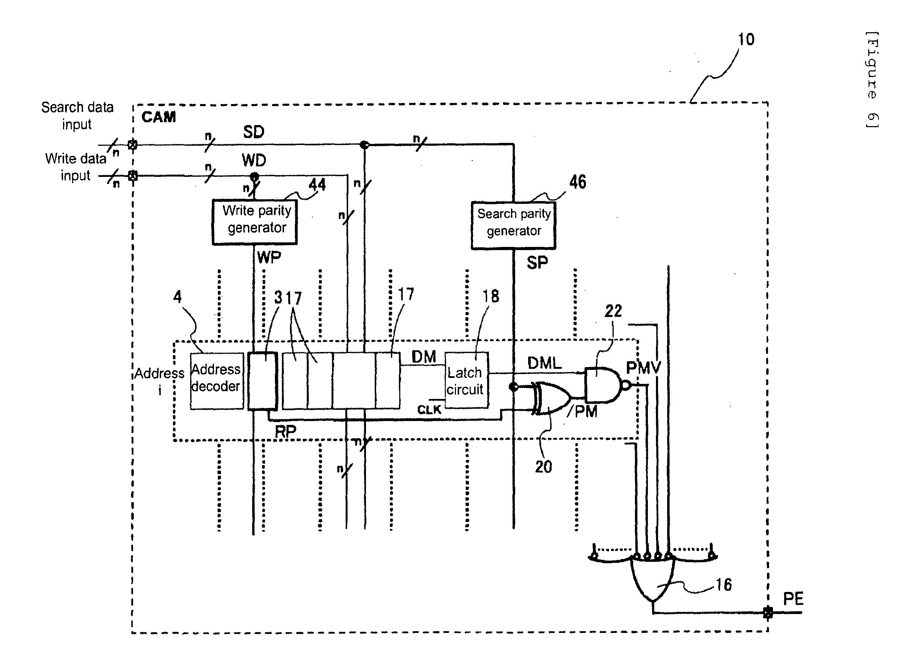

Though the write port and the search port are merged in the first embodiment, the write port and the search port coexist independently in this second embodiment. More specifically, a write parity generator 44 and a search parity generator 46 are provided separately, as shown in Figure 6. The write parity generator 44 generates a parity WP of the input n-bit write data WD. The search parity generator 46 generates a parity SP of the input n-bit search data SD. At the write time, the write data WD is written into the CAM memory cells 17, and the parity WP is calculated based on the write data WD and written into the parity memory cell 3. At the search time, the memory locations 14 corresponding to all the addresses are searched at the same time, and whether or not the data matched with the search data SD is stored in the CAM memory cells 17 is judged, while the parity SP is calculated based on the search data SD, and whether or not the parity SP is matched with the parity RP stored in the parity memory cell 3 is judged.

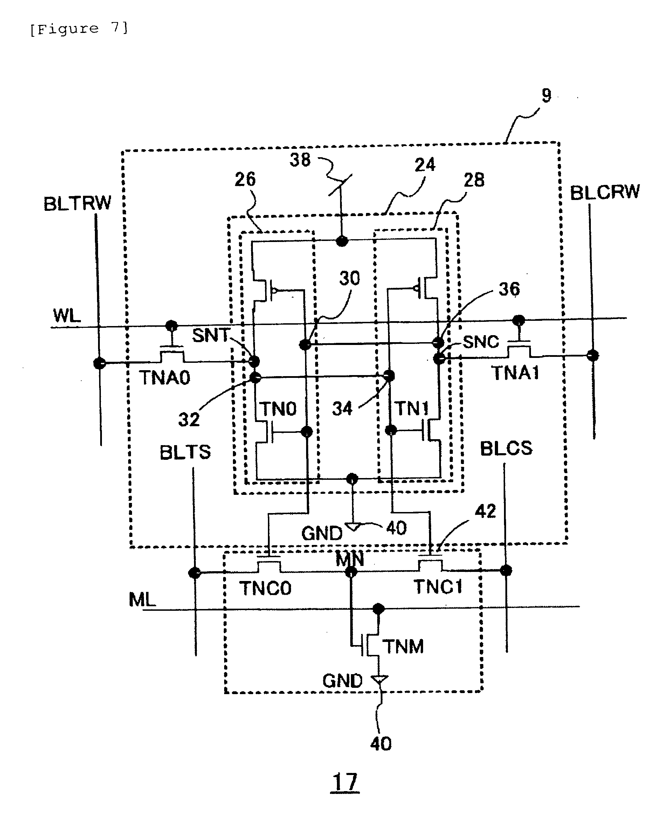

Also, the bit lines are separated into the read and write bit lines and the search dedicated bit lines. More specifically, the read and write bit lines BLTRW and BLCRW and the search dedicated bit lines BLTS and BLCS are provided separately, as shown in Figure 7. The input data WD is written via the read and write bit lines BLTRW and BLCRW into the CAM memory cells 17, and the data read from the CAM memory cells 17 is outputted via the read and write bit lines BLTRW and BLCRW. The input search data SD is given to the search dedicated bit lines BLTS and BLCS.

With this second embodiment, since the write port and the search port are provided separately, the write and search of data can be performed simultaneously.

### Third embodiment

Though the latch circuit 18 is provided in the first embodiment, the latch circuit is omitted in this third embodiment. More specifically, the word data match signal DM is given directly to the NAND circuit 22, as shown in Figure 8.

### Fourth embodiment

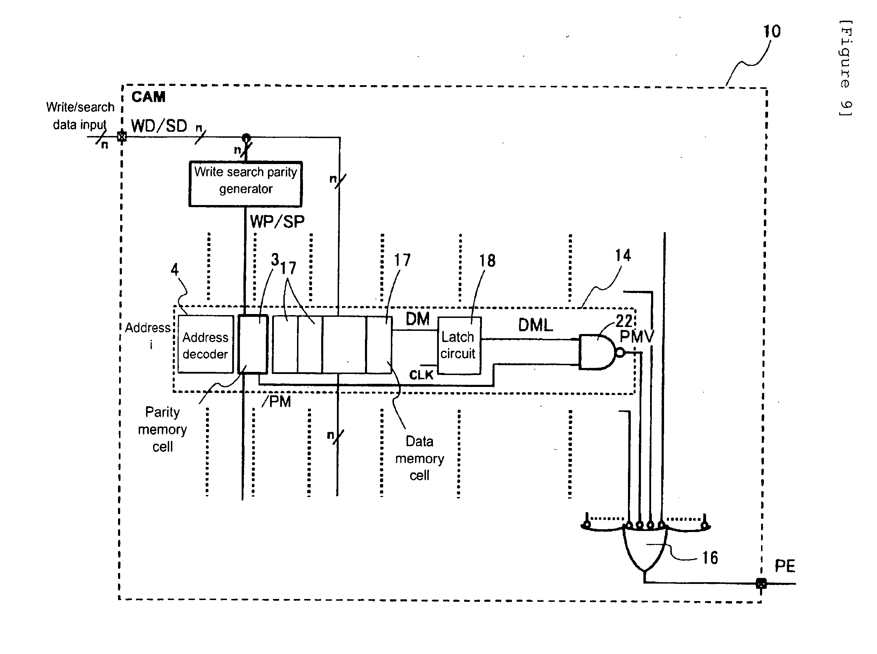

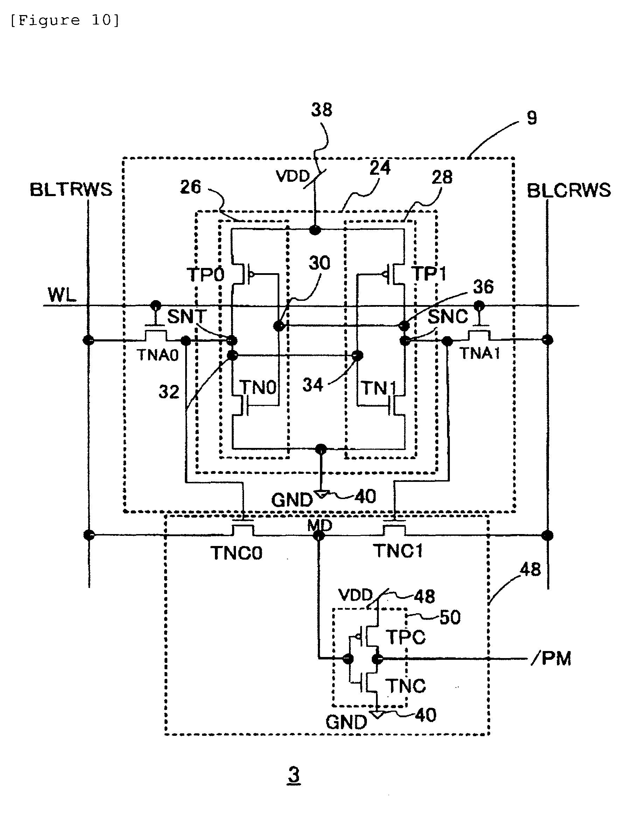

Though the exclusive OR circuit 20 is provided in the first embodiment, each parity memory cell 3 having an equivalent function is provided, instead of the exclusive OR circuit 20, in this fourth embodiment. More specifically, the parity SP of the search data SD is given to the bit lines BLTRWS and BLCRWS corresponding to the parity memory cell 3, and a parity comparator 48 is provided within the parity memory cell 3, as shown in Figures 9 and 10. The parity comparator 48 comprises the comparison transistors TNC0 and TNC1 composed of an n-channel MOS transistor respectively and a CMOS inverter 50 composed of a p-channel MOS transistor TPC and an n-channel MOS transistor TNC, judges whether or not the parity SP given via the bit lines BLTRWS and BLCRWS and the parity stored in the parity memory cell 3 are matched, and activates the parity match signal /PM to the low level if they are matched, or deactivates the parity match signal /PM to the high level if they are not matched. This parity match signal /PM is given to the NAND circuit 22.

In this fourth embodiment, the latch circuit 18 may be omitted as in the third embodiment as shown in Figure 8.

### Fifth embodiment

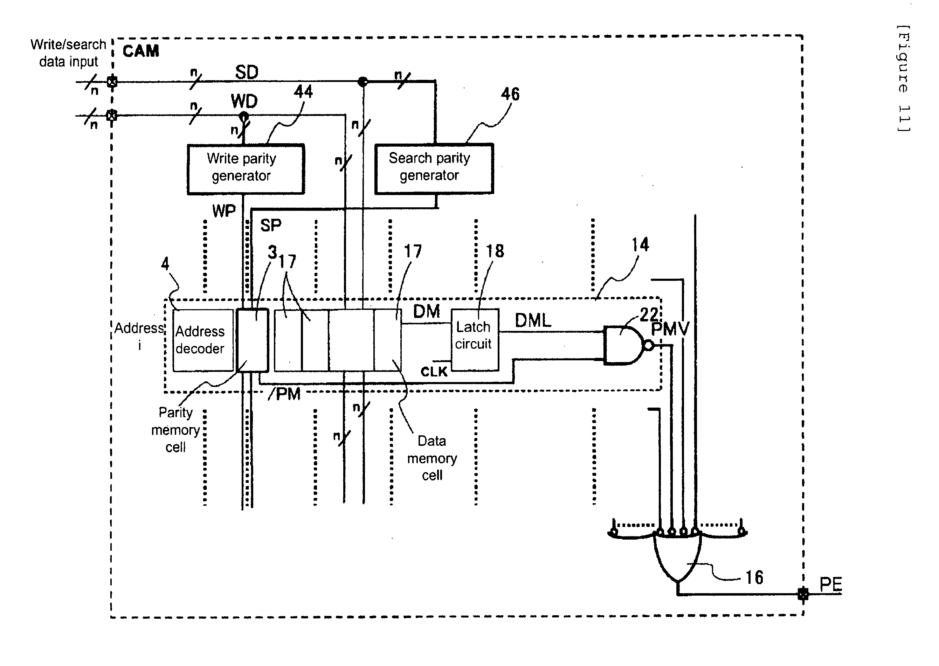

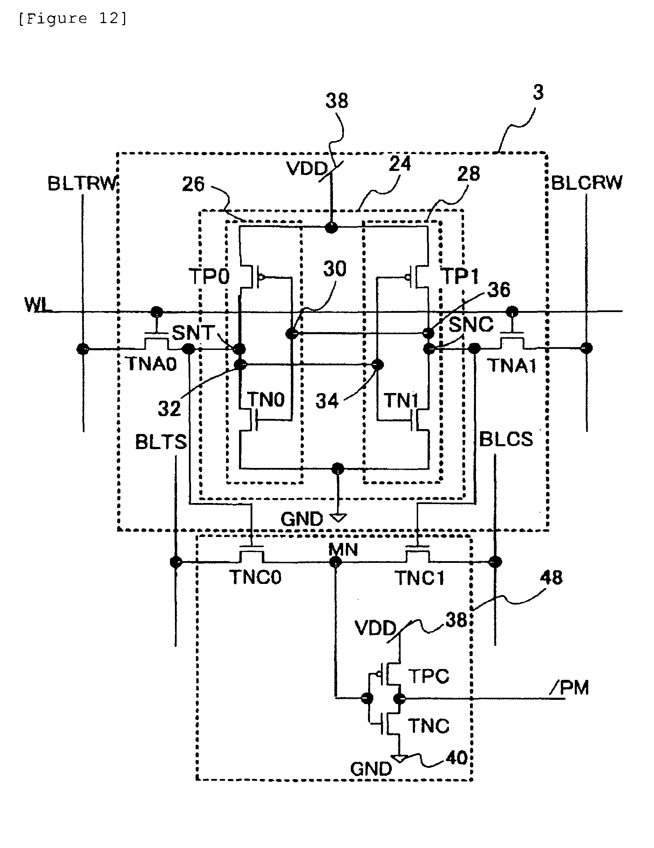

The second embodiment as shown in Figures 6 and 7 and the fourth embodiment as shown in Figures 9 and 10 may be combined. More specifically, in the fifth embodiment, the parity SP generated by the search parity generator 46 is given to the bit lines BLTS and BLCS corresponding to the parity memory cell 3, and the parity comparator 48 is provided within the parity memory cell 3, as shown in Figures 11 and 12.

In this fifth embodiment, the latch circuit 18 may be omitted as in the third embodiment as shown in Figure 8.

Besides, the logic levels, the high level and low level, may be inverted, and accordingly the logic circuit may be appropriately changed to realize the same logic as a whole.

## Claims

1. A parallel associative memory for searching all the addresses at the same time and determining whether or not the same data as input data is stored, comprising:
parity generation means (12) for generating a parity of n-bit data inputted at write time and search time; and
a plurality of memory locations (14) corresponding to a plurality of addresses;
in which each of said memory locations comprises n Content Addressable Memory, hereinafter termed CAM, memory cells (17) for storing n-bit data inputted at the write time and comparing the n-bit data inputted at the search time and the stored n-bit data;
a plurality of parity memory cells (3), each memory cell corresponding to a memory location and configured to store a parity generated by said parity generation means at the write time of n-bit data in said corresponding memory location; and
parity check means (20) comprising a plurality of parity check circuits, each parity check circuit corresponding to a parity memory cell and configured to judge whether or not a parity generated by said parity generation means at the search time and the parity stored in said parity memory cell are matched,
wherein each parity check circuit is configured to activate a parity match signal (/PM) if there is a match between the parity generated by said parity generation means at the search time and the parity stored in said corresponding parity memory cell, and each of said memory locations further comprises a word match detection circuit for activating a word data match signal (DML) to a first logic level if the n-bit data inputted at the search time and the n-bit data stored in the CAM memory cells of said memory location are matched, and parity validation means (22) comprising a plurality of parity validation circuits, each parity validation circuit corresponding to a parity memory cell and a memory location and configured to validate a corresponding parity match signal (/PM) outputted from a corresponding parity check circuit in response to the corresponding word data match signal (DML) being activated by said corresponding word match detection circuit;
**characterized in that** the activation of each parity match signal (/PM) is made at a second logic level different from the first logic level by the correspond parity check circuit and **in that** the parallel associative memory further comprising parity error detection means for activating a parity error signal (PE) at the first logic level if any one of a plurality of parity match signals validated by said parity validation means and outputted from said plurality of memory locations is inactive.

2. The parallel associative memory according to claim 1, wherein said parity generation means comprises a write parity generator for generating a parity of the n-bit data inputted at the write time, and a search parity generator for generating a parity of the n-bit data inputted at the search time.

## Patentansprüche

1. Paralleler Assoziativspeicher zum gleichzeitigen Durchsuchen aller Adressen und Ermitteln, ob dieselben Daten wie die eingegebenen gespeichert werden, wobei der Speicher umfasst:
ein Paritäts-Erzeugungsmittel (12) zum Erzeugen einer Parität von Daten mit n Bits, die zum Zeitpunkt des Schreibens und des Durchsuchens eingegeben werden; und
eine Vielzahl von Speicherplätzen (14), die mit einer Vielzahl von Adressen übereinstimmen; wobei jeder der Speicherplätze n Speicherzellen (17) mit inhaltsadressierbarem Speicher, hier als CAM (Content Adressable Memory) bezeichnet, zum Speichern von n-Bit-Daten, die zum Zeitpunkt des Schreibens eingegeben werden, und zum Vergleichen der n-Bit-Daten, die zum Zeitpunkt des Durchsuchens eingegeben werden, mit den gespeicherten n-Bit-Daten umfasst;
eine Vielzahl von Paritäts-Speicherzellen (3), wobei jede Speicherzelle mit einem Speicherplatz übereinstimmt und zum Speichern einer Parität ausgelegt ist, wobei die Parität von dem Paritäts-Erzeugungsmittel zum Zeitpunkt des Schreibens der n-Bit-Daten an den zugehörige Speicherplatz erzeugt wurde; und
ein Paritäts-Prüfmittel (20), das eine Vielzahl von Paritäts-Prüfschaltungen umfasst, wobei jede Paritäts-Prüfschaltung mit einer Paritäts-Speicherzelle übereinstimmt und zum Beurteilen ausgelegt ist, ob eine Parität, die von dem Paritäts-Erzeugungsmittel zum Zeitpunkt des Schreibens erzeugt wurde, mit der in der Paritäts-Speicherzelle gespeicherten Parität übereinstimmt,
wobei jede Paritäts-Prüfschaltung zum Aktivieren eines Paritäts-Übereinstimmungssignals (PM) ausgelegt ist, wenn eine Übereinstimmung zwischen der Parität, die von dem Paritäts-Erzeugungsmitteln zum Zeitpunkt des Durchsuchens erzeugt wird, und der in der zugehörigen Paritäts-Speicherzelle gespeicherten Parität besteht, und wobei jeder der Speicherplätze ferner eine Erkennungsschaltung für Wort-Übereinstimmungen zum Aktivieren eines Wortdaten-Übereinstimmungssignals (DML) auf einem ersten Logikpegel umfasst, wenn die zum Zeitpunkt des Durchsuchens eingegeben n-Bit-Daten und die in den CAM-Speicherzellen gespeicherten n-Bit-Daten des Speicherplatzes übereinstimmen, und wobei das Paritäts-Bestätigungsmittel (22) eine Vielzahl von Paritäts-Bestätigungsschaltungen umfasst, wobei jede Paritäts-Bestätigungsschaltung zu einer Paritäts-Speicherzelle und einem Speicherplatz gehört und zum Bestätigen eines zugehörigen Paritäts-Übereinstimmungssignals (PM) ausgelegt ist, das von einer zugehörigen Paritäts-Prüfschaltung in Reaktion darauf ausgegeben wird, dass ein zugehöriges Wortdaten-Übereinstimmungssignal (DML) von der zugehörigen Erkennungsschaltung der Wortübereinstimmung aktiviert wurde, **gekennzeichnet dadurch, dass** die Aktivierung jedes Paritäts-Übereinstimmungssignals (PM) auf einem zweiten Logikpegel realisiert wird, der von dem ersten Logikpegel durch die zugehörige Paritäts-Prüfschaltung abweicht, und dass der parallele Assoziativspeicher ferner ein Mittel zur Paritätsfehler-Erkennung zum Aktivieren eines Paritäts-Fehlersignals (PE) auf dem ersten Logikpegel umfasst, wenn irgendein Paritäts-Übereinstimmungssignal aus der Vielzahl von Paritäts-Übereinstimmungssignalen, die von dem Paritäts-Bestätigungsmitteln bestätigt und von der Vielzahl von Speicherplätzen ausgegeben wurden, inaktiv ist.

2. Paralleler Assoziativspeicher nach Anspruch 1, wobei das Paritäts-Erzeugungsmittel eine Schreibparität-Erzeugungseinheit zum Erzeugen einer Parität der n-Bit-Daten, die zum Zeitpunkt des Schreibens eingegeben werden, und eine Suchparität-Erzeugungseinheit zum Erzeugen einer Parität der n-Bit-Daten umfassen, die zum Zeitpunkt des Durchsuchens eingegeben werden.

## Revendications

1. Mémoire associative parallèle pour rechercher toutes les adresses à la même heure et déterminer si ou non les mêmes données sont mémorisées comme données d'entrée, la mémoire associative comprenant :
un moyen de génération de parité (12) pour générer une parité de données à n-bits entrées à une heure d'écriture et à une heure de recherche ; et
une pluralité d'emplacements de mémoire (14) correspondant à une pluralité d'adresses ;
chacun desdits emplacements de mémoire comprenant n cellules de mémoire adressables par contenu, désignées ci-après CAM (17), pour mémoriser des données à n-bits entrées à l'heure d'écriture et comparer les données à n-bits entrées à l'heure de recherche et les données à n-bits mémorisées ;
une pluralité de cellules de mémoire de parité(3), chaque cellule de mémoire correspondant à un emplacement de mémoire et étant configurée pour mémoriser une parité générée par ledit moyen de génération de parité à l'heure d'écriture des données à n-bits dans ledit emplacement de mémoire correspondant ; et
un moyen de vérification de parité (20) comprenant une pluralité de circuits de vérification de parité, chaque circuit de vérification de parité correspondant à une cellule de mémoire de parité et étant configuré pour estimer si une parité générée par ledit moyen de génération de parité à l'heure de recherche et la parité mémorisée dans ladite cellule de mémoire de parité concordent,
chaque circuit de vérification de parité étant configuré pour activer un signal de concordance de parité (PM) si il y a une concordance entre la parité générée par ledit moyen de génération de parité à l'heure de recherche et la parité mémorisée dans ladite cellule de mémoire de parité correspondante, et chacun desdits emplacements de mémoire comprenant en outre un circuit de détection de concordance de mots pour activer un signal de concordance de données de mot (DML) à un premier niveau logique si les données à n-bits entrées à l'heure de recherche et les données à n-bits mémorisées dans les cellules de mémoire CAM dudit emplacement de mémoire concordent, et un moyen de validation de parité (22) comprenant une pluralité de circuits de validation de parité, chaque circuit de validation de parité correspondant à une cellule de mémoire de parité et à un emplacement de mémoire et étant configuré pour valider un signal de concordance de parité correspondant (PM) sortie d'un circuit de validation de parité correspondant en réponse au signal de concordance de données de mot correspondant (DML) étant activé par ledit circuit de détection de concordance de mot correspondant ;
**caractérisée en ce que** l'activation de chaque signal de concordance de parité (PM) est faite à un second niveau logique différent du premier niveau logique par le circuit de vérification de parité correspondant et **en ce que** la mémoire associative parallèle comprend en outre un moyen de détection d'erreur de parité pour activer un signal d'erreur de parité (PE) au premier niveau logique si un quelconque d'une pluralité de signaux de concordance de parité validé par ledit moyen de validation de parité et sorti de ladite pluralité d'emplacements de mémoire est inactif.

2. Mémoire associative parallèle selon la revendication 1, dans laquelle ledit moyen de génération de parité comprend un générateur de parité d'écriture pour générer une parité des données à n-bits entrées à l'heure d'écriture et un générateur de parité de recherche pour générer une parité des données à n-bits à l'heure de recherche.
